# EUROPEAN PATENT APPLICATION

(11) **EP 4 718 994 A1**
(43) Date of publication of application: **01.04.2026**
(21) Application number: 25195572.0
(22) Date of filing: 13.08.2025
(51) Int. Cl.: H10D 84/01, H10D 84/80, H10D 30/01, H10D 8/00, H10D 10/00, H10D 62/17, H10D 64/23, H10D 84/03, H10D 84/40, H10D 30/00

(54) **SILICON ON INSULATOR INTEGRATION FOR BACKSIDE POWER DELIVERY WITH GATE ALL AROUND TRANSISTORS AND DIODE DEVICES**

(30) Priority: 27.09.2024 US 202418900336
(71) Applicant: INTEL Corporation, Santa Clara, CA 95054 (US)
(72) Inventor: Lin, Wenhe, Portland, OR, 97229 (US); Bouche, Guillaume, Portland, OR, 97211 (US); Fang, Sheng-Po, Vancouver, WA, 98686 (US); Tan, Chung Foong, Portland, OR, 97227 (US)
(74) Representative: Samson & Partner Patentanwälte mbB

(57) **Abstract**

Devices, transistor structures, systems, and techniques are described herein related to silicon on insulator (SOI) substrate integration for gate all around field effect transistors and diode devices. An integrated circuit die includes a diode device having a semiconductor layer, which is on an insulator layer of the SOI substrate, and an integrated gate all around field effect transistor fabricated within a well in the semiconductor layer to form nanoribbons each within a thickness of the semiconductor layer and absent a device subfin.

## Description

### BACKGROUND

Higher performance, lower cost, increased miniaturization, and greater density of integrated circuits (ICs) are ongoing goals of the electronics industry. To maintain the pace of increasing transistor performance, for example, multi-gate transistors such as gate-all-around (GAA) or nanoribbon transistors are being deployed. In such devices, the gate structure surrounds the channel region on all sides of each nanoribbon or ribbon of semiconductor material for improved drive current, device control, and other advantages. The nanoribbons or ribbons of semiconductor material are contacted on opposite sides by source and drain structures, with the gate, source, and drain being the GAA transistor terminals. Furthermore, the GAA transistors are integrated with other devices such as diodes, which are two terminal devices having a p-n junction between the diode terminals, or three terminal devices such as p-n-p or n-p-n bipolar junction transistors.

Currently, advantages are being sought by revealing the IC devices from the backside, inclusive of contacting the IC devices from both the frontside and backside, with the frontside being defined by the build-up direction of the device and the backside being opposite the frontside. After frontside processing that defines the devices and frontside contacts, the workpiece (i.e., wafer) may be flipped over and the workpiece substrate may be removed using grind and etch techniques. However, difficulties arise when accessing the devices from the backside. It is with respect to these and other considerations that the present improvements have been needed. Such improvements may become critical as the desire to deploy IC devices inclusive of GAA transistors and diode structures in frontside and backside contact based architectures becomes more widespread.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG.1 is a flow diagram illustrating exemplary methods for forming integrated circuit structures with laterally aligned gate all around field effect transistors and diode structures;
FIGS. 2, 3, 4, 5, 6, 7, 8, 9A, 10, and 11A are cross-sectional side views taken at a cross-fin cut of example IC structures as particular fabrication operations of the methods of FIG. 1 are performed;
FIGS. 9B and 11B are cross-sectional side views taken at a cross-gate cut of the example IC structures of FIGS. 9A and 11A, respectively;
FIG. 12 is a cross-sectional side view of a multi-layer integrated circuit device structure incorporating the integrated circuit structure of FIGS. 11A and 11B;
FIG. 13 illustrates exemplary systems employing an integrated circuit assembly including an integrated circuit die having a GAA-FET with semiconductor structures within a thickness of a semiconductor layer of a diode semiconductor; and
FIG. 14 is a functional block diagram of an electronic computing device, all in accordance with at least some embodiments of the present disclosure.

### DETAILED DESCRIPTION

One or more embodiments or implementations are now described with reference to the enclosed figures. While specific configurations and arrangements are discussed, it should be understood that this is done for illustrative purposes only. Persons skilled in the relevant art will recognize that other configurations and arrangements may be employed without departing from the spirit and scope of the description. It will be apparent to those skilled in the relevant art that techniques and/or arrangements described herein may also be employed in a variety of other systems and applications other than what is described herein.

Reference is made in the following detailed description to the accompanying drawings, which form a part hereof, wherein like numerals may designate like parts throughout to indicate corresponding or analogous elements. It will be appreciated that for simplicity and/or clarity of illustration, elements illustrated in the figures have not necessarily been drawn to scale. For example, the dimensions of some of the elements may be exaggerated relative to other elements for clarity. Further, it is to be understood that other embodiments may be utilized, and structural and/or logical changes may be made without departing from the scope of claimed subject matter. It should also be noted that directions and references, for example, up, down, top, bottom, over, under, and so on, may be used to facilitate the discussion of the drawings and embodiments and are not intended to restrict the application of claimed subject matter. Therefore, the following detailed description is not to be taken in a limiting sense and the scope of claimed subject matter defined by the appended claims and their equivalents.

In the following description, numerous details are set forth. However, it will be apparent to one skilled in the art, that the present invention may be practiced without these specific details. In some instances, well-known methods and devices are shown in block diagram form, rather than in detail, to avoid obscuring the present invention. Reference throughout this specification to "an embodiment" or "one embodiment" means that a particular feature, structure, function, or characteristic described in connection with the embodiment is included in at least one embodiment of the invention. Thus, the appearances of the phrase "in an embodiment" or "in one embodiment" in various places throughout this specification are not necessarily referring to the same embodiment of the invention. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description of the invention and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items. Herein, the term "predominantly" indicates not less than 50% of a particular material or component while the term "substantially pure" indicates not less than 99% of the particular material or component and the term "pure" indicates not less than 99.9% of the particular material or component. Unless otherwise indicated, such material percentages are based on atomic percentage. Herein the term concentration is used interchangeably with material percentage and also indicates atomic percentage unless otherwise indicated.

The terms "coupled" and "connected," along with their derivatives, may be used herein to describe structural relationships between components. It should be understood that these terms are not intended as synonyms for each other. Rather, in particular embodiments, "connected" may be used to indicate that two or more elements are in direct physical or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause an effect relationship, an electrical relationship, a functional relationship, etc.).

The terms "over," "under," "between," "on", and/or the like, as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features. The term immediately adjacent indicates such features are in direct contact. Furthermore, the terms "substantially," "close," "approximately," "near," and "about," generally refer to being within +/-10% of a target value. The term layer as used herein may include a single material or multiple materials. As used in throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C. The terms "lateral", "laterally adjacent" and similar terms indicate two or more components are aligned along a plane orthogonal to a vertical direction of an overall structure. As used herein, the terms "monolithic", "monolithically integrated", and similar terms indicate the components of the monolithic overall structure form an indivisible whole not reasonably capable of being separated.

Devices, integrated transistor and diode structures, integrated circuit dies, apparatuses, systems, and techniques are described herein related to gate-all-around field effect transistors (GAA-FETs) integrated with diodes such that the nanoribbons of the GAA-FETs are formed within a well of a semiconductor material, which is on an insulator, with the semiconductor material used to fabricate the diodes.

As discussed, multi-gate transistors such as gate-all-around (GAA) or nanoribbon transistors are being deployed in advanced integrated circuit (IC) devices and integrated with diode devices. As used herein, the terms nanowire, nanoribbon, stacked semiconductor structure, and similar terms are used substantially interchangeably to indicate a semiconductor material that extends from a source to a drain such that the semiconductor material is one of two or more such material structures that are separated and vertically aligned. The multiple semiconductor material structures each couple to the same source and drain, and are vertically separated by a gate structure, which may include a gate dielectric and a gate electrode. Thereby, the field effect transistor or device includes a source, a drain, and a stack of semiconductor structures extending between the source and the drain. The term channel region of a semiconductor structure indicates a region of a material layer adjacent to a gate dielectric and gate electrode that is to be controlled by the gate electrode to switch the transistor structure in operation. Notably, a region of a material layer need not be in operation to be characterized as a channel region, channel material, or the like. The term semiconductor structure is used broadly to include nanowires, nanoribbons, and similar terms. The term diode indicates a two or three terminal device that conducts current primarily in one direction. A diode includes a p-n junction at an interface between p-doped and n-doped semiconductor materials. When two diodes are connected back-to-back, a n-p-n or p-n-p bipolar junction transistor is formed. So, the terms diode and diode structure are used broadly herein to include n-p, p-n diode or n-p-n, p-n-p bipolar junction transistor (BJT) devices.

Furthermore, IC devices such as GAA transistors may be contacted by both the frontside and backside of the devices. As used herein, the terms frontside and backside are used in accordance with their use the art with the frontside and positive z-direction being a build-up direction of the IC devices (e.g., over a substrate) and the backside and negative z-direction being a backside of the IC devices opposite the frontside. Similarly, the terms upper, top, lower, bottom, lateral, etc. are used relative to the same orientation. In some embodiments, a diode device (e.g., diode or BJT) is contacted from only the frontside, while a gate and drain of the GAA transistor device are contacted from the frontside and the source of the GAA transistor device is contacted from the backside. However, any combination of frontside and backside contacts may be used. Although discussed with respect to backside reveal for backside contact, other reasons for backside removal such as reducing die thickness, process compatibility, and others may cause the need to remove backside substrate material. For example, the devices discussed herein may be contacted only from the frontside in some embodiments. In any event, difficulties arise when removing silicon material from the backside in silicon wafer processing. For example, the backside substrate removal may leave a subfin portion of semiconductor material the GAA transistor device, which can degrade device performance due to leakage and other concerns. Furthermore, difficulties in controlling the backside substrate removal may cause variance in the thickness of the semiconductor material used in the diode device, which also degrades performance.

In some embodiments, the semiconductor structures or nanoribbons of the GAA-FETs are formed in a well that is within a semiconductor material layer, which is in turn on an insulator of, for example, a semiconductor or silicon on insulator (SOI) wafer. Interleaved layers of semiconductor materials and sacrificial materials are formed on a thinned layer of the semiconductor material layer (which is on the insulator) within the well. The interleaved layers are patterned, and eventually the sacrificial layers are removed to release the semiconductor ribbons. Notably, prior to release, atoms, such as germanium, are diffused from the sacrificial materials into the adjacent semiconductor materials. Thereby, the released ribbons of semiconductor materials are thinned and the thinned layer of semiconductor material layer (which is on the insulator) is removed. This advantageously causes the GAA-FETs to have no subfin portion. Furthermore, regions of the semiconductor material layer on the insulator are doped to form one or more p-n junctions of a diode device (e.g., diode or BJT) within the semiconductor material layer with the semiconductor material layer being otherwise unperturbed. During backside material removal, the bulk semiconductor (Si) of the SOI wafer is removed with the insulator (i.e. silicon dioxide) acting as a nearly ideal stopping layer (e.g., etch stop or chemical mechanical polishing stop).

Using such techniques, difficulties with using non-SOI substrates are avoided. For example, removing subfins in silicon wafer processes leads to challenges in performance, yield, and reliability. Furthermore, when accessing silicon wafers from the backside, the thickness of the diode semiconductor layer is difficult to control leading to high variability in device performance. As discussed herein, an SOI substrate is used as the starting workpiece with semiconductor thickness in the range of 60 nm to 200 nm and insulator thickness in the range of 100 nm to 200 nm, and a well is formed in the semiconductor of the SOI substrate with a sub-5 nm or even sub-3 nm seed of the silicon of the SOI substrate for the superlattice epi growth of, for example SiGe/Si interleaved layers. The seed layer (after patterning) is removed as part of nanowire release to remove the device subfin. Furthermore, the resultant device layer, during backside reveal, has the insulator layer to act as a stopping layer. Advantages of such processing includes elimination of subfin devices, elimination of difficult backside processing such as etching, fin isolation, and others, improved reveal polish control (e.g., silicon polish stop on oxide), nearly ideal diode formation using SOI (e.g., lateral junction with well controlled thickness), enablement of planar or FINFET based thick gate I/O device, enablement of radio frequency stacked device on SOI, compatibility with current GAA-FET fabrication processing, and others. The final device includes co-existing GAA-FETs and SOI-based diodes. The resultant devices may include continuous BOX (buried oxide) isolation instead of fin isolation and etch back isolation.

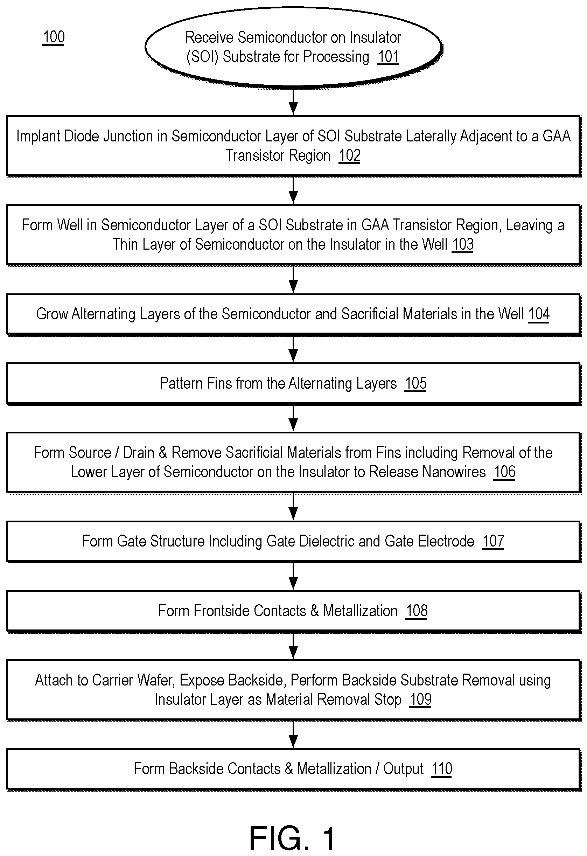

FIG.1 is a flow diagram illustrating exemplary methods 100 for forming integrated circuit structures with laterally aligned gate all around field effect transistors and diode structures, arranged in accordance with at least some implementations of the present disclosure. For example, methods 100 may be implemented to fabricate integrated circuit (IC) structures 900, 1100 or any other IC structures discussed herein. In the illustrated implementation, methods 100 include one or more operations as illustrated by operations 101-110. However, embodiments herein may include additional operations, certain operations being omitted, or operations being performed out of the order provided.

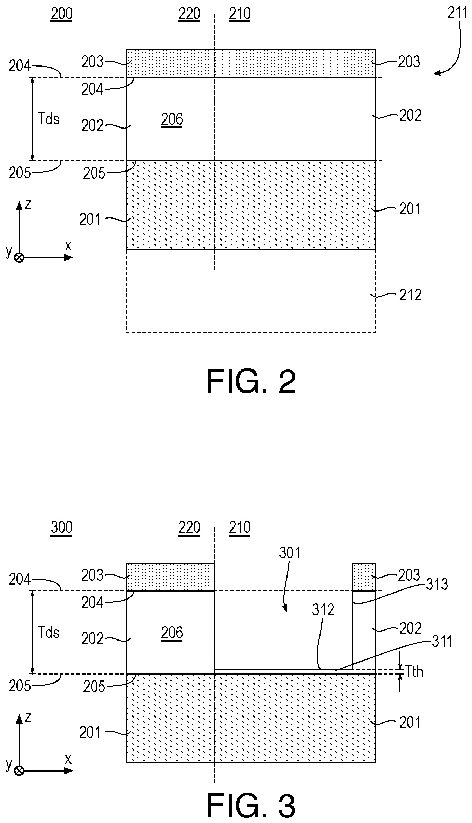

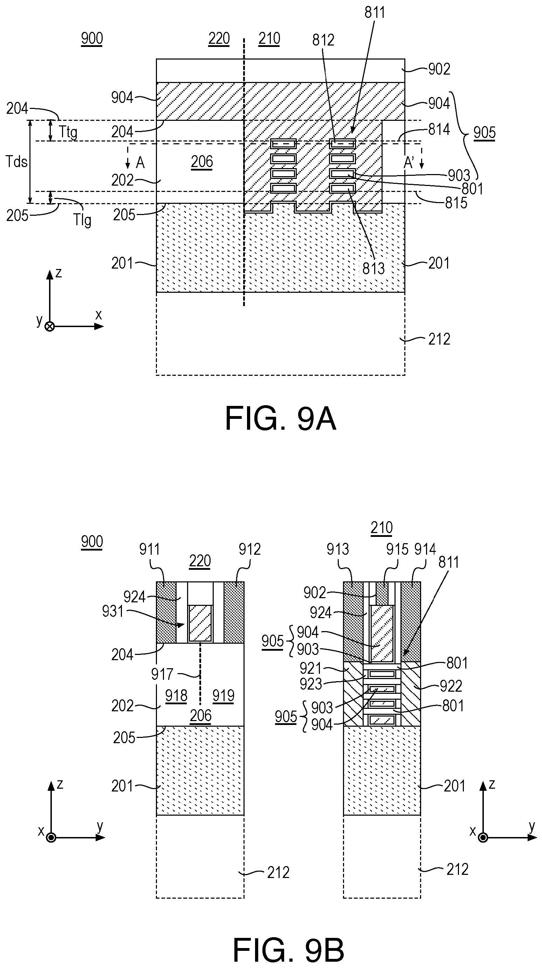

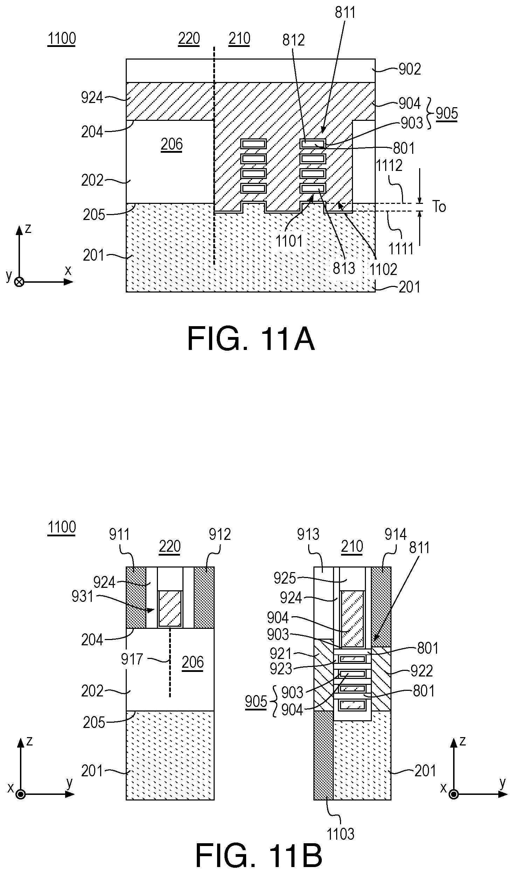

FIGS. 2, 3, 4, 5, 6, 7, 8, 9A, 10, 11A, and 12 are cross-sectional side views taken at a cross-fin cut of example IC structures as particular fabrication operations of methods 100 are performed, arranged in accordance with at least some implementations of the present disclosure. FIGS. 9B and 11B are cross-sectional side views taken at a cross-gate cut of the example IC structures of FIGS. 9A and 11A, respectively. Methods 100 may be deployed to fabricate any IC structures illustrated and discussed herein.

Processing begins at operation 101, where a workpiece such as a silicon on insulator (SOI) substrate is received for processing. Although discussed with respect to a silicon on oxide, with underlying silicon substrate-based SOI substrate, any suitable semiconductor and insulator materials may be used. In some embodiments, the substrate includes underlying devices or electrical interconnects. Processing continues at operation 102, where a diode junction is implanted in the semiconductor layer of the SOI substrate laterally adjacent to a GAA transistor region. Such implant processing may be performed at any suitable step in the discussed process flow. In some embodiments, the implant processing includes applying a first mask such as a patterned photoresist layer, implanting p- or n-doped regions, removing the first mask, applying a second mask, implanting the other of the p- and n-doped regions such that one or more p-n junctions are established in the semiconductor layer on the insulator, and removing the second mask. The p-n junction(s) may be formed using any suitable architectures such as laterally adjacent doped regions, well-within-well structures, or others.

Processing continues at operation 103, where a well is formed in the semiconductor layer of the SOI substrate in a GAA-FET region such that a thin layer of the semiconductor layer of the SOI substrate is left at a bottom of the well. The well may be formed using any suitable technique or techniques such as anisotropic etch processing including reactive ion etching. In some embodiments, a mask such as a hard mask is used to protect non-well portions of the semiconductor layer. For example, the pattern of the well may first be transferred to the hardmask using a patterned photoresist, and then transferred to form well within the semiconductor layer of the SOI substrate. As discussed, a thin layer of semiconductor layer is left within the well as a seed layer, with the thickness being carefully controlled for later removal during nanowire release.

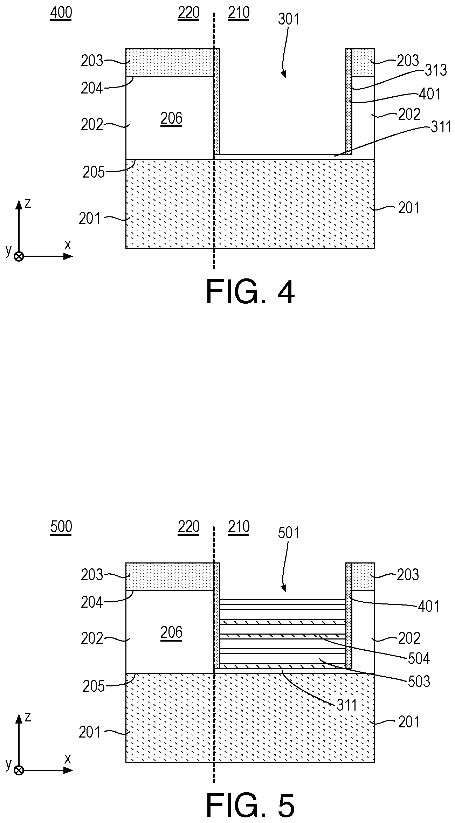

FIG. 2 is a cross-sectional side view of an example IC structure 200. As shown, IC structure 200 includes an SOI substrate 211 that includes a semiconductor layer 202 on an insulator layer 201, and an underlying bulk layer 212. In FIGS. 3-8, bulk layer 212 is not illustrated for the sake of clarity of presentation. Semiconductor layer 202 may include any suitable material or materials and, in some embodiments, semiconductor layer 202 includes a material or materials having the same or a similar composition with respect to subsequently formed semiconductor ribbons of the GAA-FETs being fabricated. For example, semiconductor layer 202 may be the same material as semiconductor layers 503 grown at operation 103 (see FIG. 5). In some embodiments, semiconductor layer 202 and semiconductor layers 503 include a Group IV material (e.g., silicon). In some embodiments, semiconductor layer 202 and semiconductor layers 503 are monocrystalline silicon.

As shown, semiconductor layer 202 has an upper or top surface 204 and a lower or bottom surface 205, which define corresponding planes that are labeled using the same reference numbers. Such labeling convention is used throughout such that planes defined by particular structure features are labeled using the same reference numbers for the sake of clarity. A diode structure 220 (e.g., diode or BJT) is fabricated in a diode region of semiconductor layer 202 and a transistor structure 210 (e.g., GAA-FET) is fabricated in a transistor region of semiconductor layer 202. Diode structure 220 and transistor structure 210 are integrated into an IC die, for example. In some embodiments, the transistor region is 99% or more of the area of IC structure 200 with the diode region making up about 1% of the area, however, any suitable layouts may be used. FIGS. 2, 3, 4, 5, 6, 7, 8, 9A, 9B, 10, 11A, 11B, and 12 illustrate IC structures as diode structure 220 and transistor structure 210 evolve during processing.

By deploying SOI substrate 211, semiconductor layer 202 has high quality and a substantially constant thickness that will be maintained throughout processing to fabricate diode structure 220, and therefore the thickness is labeled Tds (thickness of diode structure). Thickness Tds extends orthogonally from top surface 204 to bottom surface 205, and thickness Tds may be any suitable thickness based on design criteria. In some embodiments, thickness Tds is not less than 60 nm and not more than 200 nm. In some embodiments, thickness Tds is about 150 nm. In some embodiments, thickness Tds is about 80 nm. In some embodiments, thickness Tds is not less than 60 nm and not more than 100 nm. In some embodiments, thickness Tds is not less than 100 nm and not more than 200 nm. As shown, diode structure 220 includes any number of diode junctions such as diode junction 206, which may have any suitable architecture within semiconductor layer 202, and therefore, diode junction 206 is illustrated generally. For example, diode junction 206 may be a p-n junction formed using implantation of dopants as is known in the art.

As shown, SOI substrate 211 advantageously includes a buried insulator layer 201, which may be any suitable material. In some embodiments, insulator layer 201 is silicon oxide (e.g., SiO₂) such that insulator layer 201 includes silicon and oxygen. In some embodiments, insulator layer 201 may be characterized as a BOX (buried oxide) layer. Notably, the thickness of insulator layer 201 may be compatibility with subsequent backside processing. Underlying bulk layer 212 may be any suitable material that provides structural support during processing such as silicon or other material. IC structure 200 further includes a hardmask 203. In some embodiments, hardmask 203 is or includes silicon nitride (e.g., includes silicon and nitrogen). In some embodiments, hardmask 203 includes a silicon nitride layer on an oxide layer.

FIG. 3 is a cross-sectional side view of an example IC structure 300 similar to IC structure 200 after the formation of a well 301 within semiconductor layer 202. Well 301 may be formed using any suitable technique or techniques such as such as anisotropic etch processing including reactive ion etching. In some embodiments, well 301 is formed using a time etch down to a desired thickness of a thinned or thin portion 311. Notably, insignificant loading effects are witnessed as it substantially a blanket etch. Well 301 may accommodate any number of transistor structures 210 and may be sized appropriately. The areas outside of well 301 may be diode regions or regions for other devices. The depth of well 301 may be selected based a number of nanoribbons for transistor structures 210, for example. Well 301 includes a sidewall 313 and a bottom surface 312 within semiconductor layer 202. As shown, forming well 301 provides for thinned or thin portion 311 of semiconductor layer 202 having a thickness Tth between bottom surface 312 of well 301 and insulator layer 201 (i.e., a top surface of insulator layer 201). The thickness Tth is carefully tuned such that the corresponding semiconductor material that remains after epitaxial growth of interleaved layers and patterning is removed during nanoribbon release. In some embodiments, thin portion 311 of semiconductor layer 202 has a thickness Tth of not more than 5 nm. In some embodiments, thickness Tth is not more than 5 nm and not less than 2 nm. In some embodiments, thickness Tth is not more than 3 nm. Other thicknesses may be used. Furthermore, thickness Tth can be well controlled in etch processing to about +/- 5 angstroms.

Returning to FIG. 1, processing continues at operation 104, where an interleaved stack of alternating layers of semiconductor material layers and sacrificial layers are formed within the well, over the insulator layer, and laterally adjacent to the diode junction of the diode structure. The alternating layers of semiconductor material layers and sacrificial layers may be formed using any suitable technique or techniques such as epitaxial growth techniques, deposition techniques or the like. In some embodiments, the sidewalls of the well are passivated with a thin liner such as a silicon nitride liner (a liner including silicon and nitrogen) or a silicon oxide liner (a liner including silicon and oxygen) to prevent lateral epitaxial growth. A subsequent epitaxial growth forms the multilayer stack of interleaved semiconductor layers (i.e., materials for eventual nanowires) and sacrificial layers (i.e., materials to be removed to release the nanowires).

FIG. 4 is a cross-sectional side view of an example IC structure 400 similar to IC structure 300 after formation of liner 401 on sidewall 313 of well 301. In some embodiments, liner 401 is deposited using conformal deposition such as chemical vapor deposition (CVD) or atomic layer deposition (ALD), followed by an etch such as an anisotropic etch to remove planar sections of the bulk liner material. This leaves liner 401 on sidewall 313 of well 301. As discussed, liner 401 may be a dielectric material such as silicon nitride or silicon oxide.

FIG. 5 is a cross-sectional side view of an example IC structure 500 similar to IC structure 400 after formation of multilayer stack 501 of alternating or interleaved semiconductor layers 503 and sacrificial layers 504. Portions of semiconductor layers 503 will eventually form semiconductor structure or nanoribbons of GAA-FETs. Semiconductor layers 503 and sacrificial layers 504 may be formed using any suitable technique or techniques such as CVD, ALD, physical vapor deposition (PVD), or plasma-enhanced chemical vapor deposition (PECVD). In some embodiments, semiconductor layers 503 and sacrificial layers 504 are formed using epitaxial growth techniques. In some embodiments, semiconductor layers 503 and sacrificial layers 504 are epitaxially grown within well 301 using thin portion 311 of semiconductor layer 202 as a seed layer.

As discussed, in some embodiments, semiconductor layers 503 are the same material as semiconductor layer 202. In some embodiments, semiconductor layers 503 are silicon and sacrificial layers 504 are silicon germanium (i.e., include silicon and germanium). In some embodiments, semiconductor layers 503 are monocrystalline silicon and sacrificial layers 504 are monocrystalline silicon germanium. In some embodiments, sacrificial layers 504 are silicon germanium and semiconductor layers 503 are a semiconductor material suitable for use as a nanoribbon such as silicon, germanium, or III-V materials such as indium phosphide (i.e., includes indium and phosphorus) or gallium arsenide (i.e., includes gallium and arsenic). Any number of semiconductor layers 503 and sacrificial layers 504 may be formed to provide any number of nanowires. In some embodiments, IC structure 500 includes six semiconductor layers 503 to form four eventual nanowires.

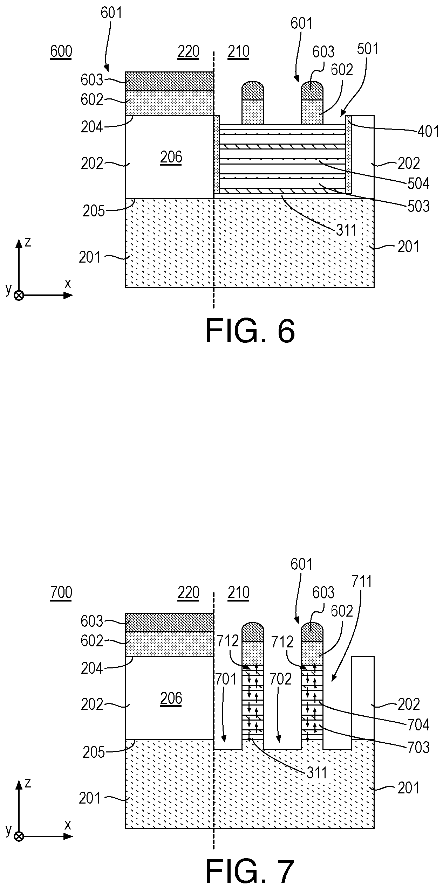

Semiconductor layers 503 and sacrificial layers 504 may have any suitable thicknesses such as thickness of not less than 5 nm and not more than 20 nm. In some embodiments, as discussed with respect to FIG. 7, atoms of sacrificial layers 504 are diffused into semiconductor layers 503 to thin semiconductor layers 503 as well as to remove the remaining part of thin portion 311 of semiconductor layer 202. In some embodiments, a part of an upper one of semiconductor layers 503 is also removed using such techniques.

Returning to FIG. 1, processing continues at operation 105, where fins or fin structures are patterned from the interleaved stack of semiconductor material layers and sacrificial layers formed at operation 104. The fins or fin structures may be patterned using any suitable technique or techniques. In some embodiments, the hardmask used to define the wells is removed and a mask structure defining the fins and covering the diode regions is formed. A subsequent etch may be used to form the fins.

FIG. 6 is a cross-sectional side view of an example IC structure 600 similar to IC structure 500 after removal of hardmask 203 as well as portions of liner 401, and after formation of mask structure 601. As shown, in some embodiments, mask structure 601 includes a first material layer 602 such as silicon oxide on a second material 603 such as silicon nitride. However, any suitable material system may be used. In some embodiments, mask structure 601 is a single material layer. In some embodiments, mask structure 601 is a single layer of a carbon hardmask material or silicon nitride. Hardmask 203 as well as portions of liner 401 may be removed using any suitable technique or techniques such as wet etch processing, chemical mechanical polishing (CMP), or the like.

Mask structure 601 may be formed by deposition and patterning using a resist pattern, for example. Mask structure 601 defines rows of fins from the underlying multilayer stack 501. The rows of fins extend in the y-direction (i.e., into and out of the page). Furthermore, mask structure 601 covers diode structure 220 during processing of transistor structures 210. It is noted that a slight height difference between top surface 204 and the top surface of an uppermost layer of multilayer stack 501 is acceptable. In some embodiments, the thickness of semiconductor layer 202 in the diode region may be tuned as part of incoming SOI substrate 211 or using oxidation prior to application of hardmask 203.

FIG. 7 is a cross-sectional side view of an example IC structure 700 similar to IC structure 600 after removal of portions of multilayer stack 501 to define fin structures 711. As shown, each of fin structures 711 includes alternating layers of interleaved patterned semiconductor layers 703 and patterned sacrificial layers 704. In some embodiments, an anisotropic etch is performed to define fin structures 711. As shown, in some embodiments, such etch processing removes portions of insulator layer 201 to define recesses 701, 702. However, in some embodiments, recesses 701, 702 may not be evident.

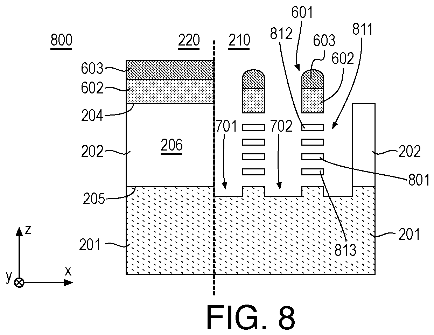

As shown with respect to diffusion 712, atoms may diffuse 712 from patterned sacrificial layers 704 to patterned semiconductor layers 703 and the patterned portion of thin portion 311 of semiconductor layer 202. Such diffusion may be diffusion of germanium from silicon germanium patterned sacrificial layers 704 to silicon patterned semiconductor layers 703 and the patterned portion of thin portion 311 of semiconductor layer 202, for example. Although illustrated with respect to diffusion after patterning of fin structures 711, such diffusion may take place at any and multiple stages of processing. Such diffusion 712 may be provided as a diffusion operation using thermal processing, in some examples. In some embodiments, diffusion 712 is a byproduct of other processing that has thermal processes or cycles used in other operations. In any event, diffusion 712 causes patterned semiconductor layers 703 to effectively thin as the interface between materials that will be removed and remain after a subsequent etch move with diffusion 712. After etch processing (see FIG. 8), diffusion 712 causes eventual thing of remaining materials from patterned semiconductor layers 703 and causes the full remove of the patterned portion of thin portion 311 due to diffusion 712. Thereby, the resultant GAA-FET does not have a subfin portion for improved performance.

Returning to FIG. 1, processing continues at operation 106, where source and drains are formed and the nanowires are released. Such processing may include any suitable technique or techniques. In some embodiments, a dummy gate is formed over and extending orthogonal to the fin structures. The fin structures may then be patterned and the sacrificial materials recessed and filled with a spacer material. Subsequently, a source and a drain may be epitaxially grown from opposite sides of the exposed semiconductor materials (with the sacrificial materials obscured by the spacer material). The source and the drain then provide mechanical and structural support during removal of sacrificial material layers and release of the remaining semiconductor materials to form nanowires of the GAA-FETs. The sacrificial material layers may be removed using any suitable technique or techniques such as wet etch techniques based on the etch selectivity is provided between the sacrificial material layers and the semiconductor material layers due to the differing materials deployed (e.g., silicon germanium sacrificial material layers and substantially pure or pure silicon semiconductor material layers).

FIG. 8 is a cross-sectional side view of an example IC structure 800 similar to IC structure 700 after removal of patterned sacrificial layers 704 to release a stack 811 of semiconductor structures 801, which may be referred to as nanowires or nanoribbons or the like. As discussed, semiconductor structures 801 may be supported by a source structure and a drain structure which are into and out of the page with respect to the cross-fin cut illustrated in FIG. 8. Such structures and other components of transistor structure 210 are illustrated herein below with respect to the cross-gate cut of FIGS. 9B and 11B.

Returning to FIG. 1, processing continues at operation 107, where the sacrificial materials removed at operation 106 are replaced by a gate structure, which may include a gate dielectric material on at least portions of the semiconductor structures (i.e., nanoribbons), and a gate electrode (e.g., gate metal) on the gate dielectric material. The gate structure may be formed using any suitable technique or techniques. In some embodiments, the gate dielectric material is be formed using conformal deposition processing, and the gate electrode is formed by conformal deposition (of a work function metal) followed by metal fill. However, other fabrication techniques may be used.

Processing continues at operation 108, where frontside metal contacts for the diode structure and one or more of a frontside metal source contact, a frontside metal drain contact, and a frontside metal gate contact are coupled to the source, drain, and gate of the transistor structure. The diode structure and transistor structure are contacted by frontside metal contacts using any suitable technique or techniques such as patterning to form openings in a dielectric material, bulk metal deposition, and CMP processing to remove overburden as is known in the art. For example, frontside contacts may be made to any one or more of the three terminals, source, drain, and gate, of the transistor structure being fabricated. The frontside contacts are then interconnected by metallization layers over the frontside contact. In some embodiments, the gate and drain of the transistor structure are contacted from the frontside to provide signal routing and the source of the transistor structure is contacted from the backside to provide power delivery. However, any interconnect routing may be used. In some embodiments, only frontside contacts are used.

FIG. 9A is a cross-sectional side view of an example IC structure 900 similar to IC structure 800 after formation of gate structure 905, which includes gate dielectric layer 903 and a gate metal 904, as well as frontside contacts. As discussed, FIG. 9A is a cross-fin cut illustration of IC structure 900. FIG. 9B is a cross-sectional side view of IC structure 900 taken at a cross-gate cut, which illustrates components not shown in the cross-fin views. As shown in FIG. 9B, transistor structure 210 includes a source structure 921 and drain structure 922, which may be epitaxial to semiconductor structures 801. In some embodiments, source structure 921 and drain structure 922 may each include an epitaxial nucleation layer and a bulk epitaxial material. FIGS. 9A and 9B also illustrate underlying bulk layer 212, which is removed in subsequent operations.

Source structure 921 and drain structure 922 may be fabricated using CVD or other epitaxial deposition techniques such that source structure 921 and drain structure 922 are epitaxial to semiconductor structures 801. Source structure 921 and drain structure 922 may be epitaxial bodies such as doped epitaxial silicon or doped epitaxial silicon and germanium (SiGe). For example, source structure 921 and drain structure 922 may each include silicon and a dopant or silicon, germanium, and a dopant. In some embodiments, the dopant is boron or gallium for PMOS devices and phosphorous or arsenic for NMOS devices, although other suitable dopants may be used.

Transistor structure 210 further includes spacers 924. For example, the previously discussed fin structures 711 may be patterned under a dummy gate and spacers 924. In some embodiments, spacers 924 are a dielectric material. Transistor structure 210 includes spacers 923 between adjacent ones of semiconductor structures 801 as well as between source structure 921 and gate structure 905 and between gate structure 905 and drain structure 922. For example, as discussed, patterned sacrificial layers 704 may be recessed and backfilled with spacers 923. Spacers 923 may be any suitable dielectric material.

With reference to FIGS. 9A and 9B, fabrication of gate structure 905 may also include the formation of isolation material 902, which may include any suitable dielectric material such as silicon oxide, silicon nitride, silicon oxynitride, or the like. As discussed, gate structure 905 may be formed by conformal deposition of gate dielectric layer 903 followed by conformal deposition of a work function metal of gate metal 904 followed by metal fill of a remainder of gate metal 904. In some embodiments, gate dielectric layer 903 includes a layer that is or includes aluminum oxide, hafnium oxide, zirconium oxide, titanium silicon oxide, hafnium silicon oxide, or silicon nitride. For example, gate dielectric layer 903 may include aluminum and oxygen; hafnium and oxygen; zirconium and oxygen; titanium, silicon, and oxygen; hafnium, silicon, and oxygen; or silicon and nitrogen. In some embodiments, gate metal 904 includes a work function layer of platinum, nickel, titanium nitride, or tantalum nitride and a fill metal such as tungsten. However, other material systems may be used. As shown, formation of gate structure 905 may also include the formation of a dummy or inoperable gate structure 931 over semiconductor layer 202 in the diode region. However, in some embodiments, inoperable gate structure 931 is not present.

As also shown in FIG. 9B, diode structure 220 includes diode junction 206, which may have any suitable architecture within semiconductor layer 202 such as a first impurity dopant type doped region 918 (i.e., p-type or n-type) and a second impurity dopant type doped region 919 (i.e., the other of p-type and n-type) meeting at a diode interface 917. and therefore, diode junction 206 is illustrated generally. Diode junction 206 may have any suitable architecture within semiconductor layer 202.

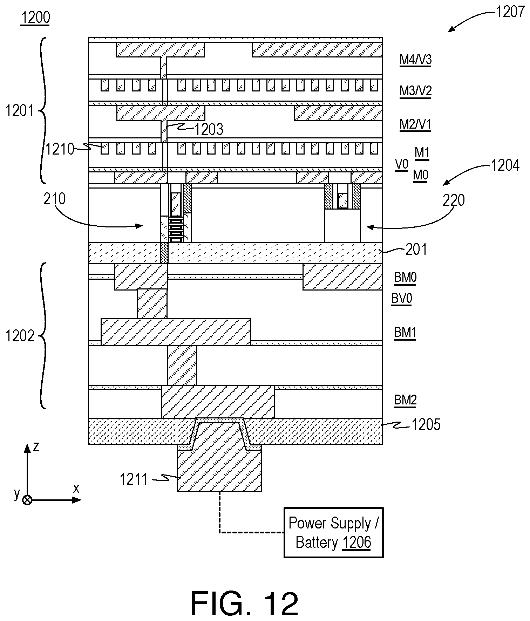

Diode structure 220 includes a first frontside contact 911 and a second frontside contact 912 each on top surface 204 of semiconductor layer 202. Transistor structure 210 includes a source frontside contact 913, a drain frontside contact 914, and a gate frontside contact 915. Although illustrated with all frontside contacts, in some embodiments, transistor structure 210 includes at least one backside contact as illustrated herein below. Frontside contacts 911, 912, 913, 914, 915 may be formed using operations known in the art such as lithography and etch to pattern openings followed by metal fill and optional planarization to form frontside contacts 911, 912, 913, 914, 915. Such components may include any suitable materials. For example, contacts 911, 912, 913, 914, 915 may include a liner material such as titanium nitride and a fill metal such as tungsten. However, other material systems may be used. Over diode structure 220 and transistor structure 210, frontside metallization layers may be formed using any suitable technique or techniques such as dual damascene techniques, single damascene techniques, subtractive metallization patterning techniques, or the like. Frontside metallization layers are illustrated herein below with respect to FIG. 12. Notably, frontside metallization layers may be formed prior to mounting IC structure 900 to a carrier wafer and performing optional backside processing as discussed below.

With reference to FIGS. 9A and 9B, IC structure 900 includes diode structure 220 (e.g., a diode or BJT) including frontside contacts 911, 912 each coupled to top surface 204 of semiconductor layer 202, which includes diode junction 206. Semiconductor layer 202 has thickness Tds extending orthogonally from top surface 204 to bottom surface 205 of semiconductor layer 202. IC structure 900 includes transistor structure 210 including stack 811 of semiconductor structures 801, which extend between source structure 921 and drain structure 922. Transistor structure 210 further includes gate structure 905 coupled to each of semiconductor structures 801. For example, gate structure 905 includes gate dielectric layer 903 on each of semiconductor structures 801 and gate metal 904 on gate dielectric layer 903.

As shown, each of semiconductor structures 801 is laterally within thickness Tds of semiconductor layer 202. That is, when extending the planes of top surface 204 and bottom surface 205, each of semiconductor structures 801 is between the two planes. Furthermore, bottom surface 205 of semiconductor layer 202 defines a plane not less than 6 nm and not more than 12 nm below a second plane defined by a bottom surface of lower-most semiconductor structure 813. That is, a plane defined by the bottom surface of the bottom or lower-most semiconductor structure 813 is spaced apart from the plane defined by bottom surface 205 by a distance Tlg. In some embodiments, the distance Tlg is not less than 6 nm and not more than 12 nm. In some embodiments, the distance Tlg is not less than 6 nm. In some embodiments, the distance Tlg is not less than 4 nm and not more than 10 nm. In some embodiments, the distance Tlg is not less than 8 nm and not more than 10 nm. Other distances Tlg may be evident as established by the discussed removal of thin portion 311 of semiconductor layer 202.

In a similar manner, in some embodiments, top surface 204 of semiconductor layer 202 defines a plane not less than 6 nm and not more than 12 nm above a plane defined by a top surface of an upper-most semiconductor structure 812. That is, a plane defined by the top surface of the top or upper-most semiconductor structure 812 is spaced apart from the plane defined by top surface 204 by a distance Ttg. In some embodiments, the distance Ttg is not less than 6 nm and not more than 12 nm. In some embodiments, the distance Ttg is not less than 6 nm. In some embodiments, the distance Ttg is not less than 4 nm and not more than 10 nm. In some embodiments, the distance Ttg is not less than 8 nm and not more than 10 nm. Other distances Ttg may be used.

Returning to FIG. 1, processing continues at operation 109, where the workpiece may be mounted, by its frontside, to a carrier such as a carrier wafer, and the backside of a device layer including the diode structure and the transistor structure is exposed through the backside of the substrate of the workpiece using the semiconductor layer and/or the gate metal formed from the frontside as material removal stops. The workpiece may be mounted to the carrier using any suitable technique or techniques such as application of an adhesive film between the workpiece and carrier. The device layer is then exposed using any suitable technique or techniques such as backside substrate removal processing including backside grind, backside etch, backside CMP, or the like. As discussed, the semiconductor layer and/or the gate metal provide an etch stop, CMP stop, or generally a selective stop layer. For example, the difference in materials between the insulator of the SOI substrate and the semiconductor layer of the SOI substrate as well as the difference in materials between the insulator of the SOI substrate and gate metal provide an efficient selective stop layer during etch or CMP processing.

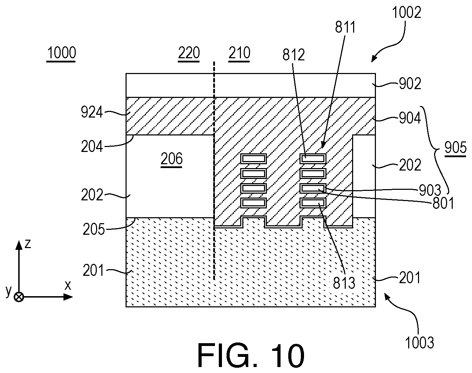

FIG. 10 is a cross-sectional side view of an example IC structure 1000 similar to IC structure 900 after removal of bulk layer 212 of SOI substrate 211 (see FIG. 9A). In some embodiments, a carrier substrate (not shown) is coupled to IC structure 1000 over frontside 1002 and bulk layer 212 is removed using backside grind, backside etch, backside CMP, or the like. As discussed, insulator layer 201 provide an etch stop, CMP stop, or generally a selective stop layer. In some embodiments, insulator layer 201 is thinned down to a desired target thickness by backside etch or CMP.

Returning to FIG. 1, processing continues at operation 110, where optional backside metal contacts for the transistor structure are formed, optional backside metallization layers are fabricated, and the workpiece is further processed and output. In some embodiments, a backside metal contact is made to the source structure of the transistor structure. The backside metal contact may be made using any suitable technique or techniques such as replacement of a dummy contact formed from the frontside or patterning, metal deposition, and CMP processing as is known in the art. Although discussed with respect to a transistor source backside contact, any terminal of the diode structure and/or transistor structure may be made. The backside contacts are then interconnected by metallization layers over the backside contacts. In some embodiments, the gate and drain of the transistor structure as well as both terminals of the diode structure are contacted from the frontside to provide signal routing, and the source of the transistor structure is contacted from the backside to provide power delivery. However, any interconnect routing may be used. Subsequently, metallization is formed over the source contact, additional fabrication processes may be completed, and the resultant structure may be output. Such processing may include backend processing, dicing, packaging, assembly, and so on. The resultant device (e.g., integrated circuit die) may then be implemented in any suitable form factor device such as a laptop, a netbook, a notebook, an ultrabook, a smartphone, a tablet, a personal digital assistant, an ultra-mobile PC, a mobile phone, a desktop computer, a server, a printer, a scanner, a monitor, a set-top box, an entertainment control unit, a digital camera, a portable music player, a digital video recorder, or the like.

FIG. 11A is a cross-sectional side view of an example IC structure 1100 similar to IC structure 1000 after formation of a backside source contact 1103 (not shown in FIG. 11A, see FIG. 11B) embedded in insulator layer 201. As discussed, FIG. 11A is a cross-fin cut illustration of IC structure 1100. FIG. 11B is a cross-sectional side view of IC structure 1100 taken at a cross-gate cut, similar to that of FIG. 9B. FIG. 11B illustrates backside source contact 1103 coupled to source structure 921. Backside source contact 1103 may be formed using any suitable technique or techniques. In some embodiments, backside contact 1103 is formed by a placeholder from front side processing or backside contact 1103 is formed by direct backside contact formation. In some embodiments, backside source contact 1103 includes a liner material such as titanium nitride and a fill metal such as tungsten. However, other materials may be used. As discussed, backside contact may be made to any terminal of transistor structure 210.

With reference to FIG. 11B, IC structure 1100 includes diode structure 220 (e.g., a diode or BJT) including frontside contacts 911, 912 each coupled to top surface 204 of semiconductor layer 202, which includes diode junction 206. Semiconductor layer 202 has thickness Tds extending orthogonally from top surface 204 to bottom surface 205 of semiconductor layer 202. IC structure 1100 further includes transistor structure 210 including stack 811 of semiconductor structures 801, which extend between source structure 921 and drain structure 922. Transistor structure 210 further includes gate structure 905 coupled to each of semiconductor structures 801. For example, gate structure 905 includes gate dielectric layer 903 on each of semiconductor structures 801 and gate metal 904 on gate dielectric layer 903. Each of semiconductor structures 801 is laterally within thickness Tds of semiconductor layer 202. Furthermore, a portion 1101 of gate metal 904 extends from gate dielectric layer 903 on the bottom surface of lower-most semiconductor structure 813 to a portion of gate dielectric layer 903 on insulator layer 201.

In some embodiments, IC structure 1100 further includes a portion 1102 of gate metal 904 such that portion 1102 is laterally adjacent to portion 1101. As shown, portion 1101 gate metal 904 has a first surface 1112 adjacent insulator layer 201. Portion 1102 of gate metal 904, which is laterally adjacent to portion 1101 of gate metal 904, has a surface 1111 also adjacent insulator layer 201 that is offset toward backside dielectric layer by a distance or thickness of To (i.e., thickness offset). In some embodiments, the thickness offset To between the surfaces 1112, 1111 of portions 1102, 1101 is not less than 1 nm. In some embodiments, the thickness offset To is not less than 2 nm. In some embodiments, the thickness offset To is not less than 5 nm. Other offsets may be used.

With reference to operation 110 of FIG. 1, processing continues backside metallization, and additional fabrication processes such as backend processing, dicing, packaging, assembly, and so on. Furthermore, with reference to operation 108, frontside metallization may have been previously fabricated, prior to backside processing. Furthermore, the resultant IC die may then be deployed in any suitable form factor device.

FIG. 12 is a cross-sectional side view of a multi-layer integrated circuit device structure 1200 incorporating IC structure 1100, in accordance with at least some embodiments of the present disclosure. Although illustrated and discussed with respect to transistor structure 210 and diode structure 220 of IC structure 1100 (see FIGS. 11A and 11B), any transistor structure and diode structure at any stage of processing discussed herein may be deployed in the context of multi-layer integrated circuit device structure 1200. For example, IC structure 900 (see FIGS. 9A and 9B) may be implemented in multi-layer integrated circuit device structure 1200. As shown, multi-layer integrated circuit device structure 1200 is incorporated in integrated circuit (IC) die 1207 such that multi-layer integrated circuit device structure 1200 includes frontside metallization layers 1201 (or frontside interconnect layers) and backside metallization layers 1202 (or backside interconnect layers). Frontside metallization layers 1201 and backside metallization layers 1202 may be formed using any suitable technique or techniques such as dual damascene techniques, single damascene techniques, subtractive metallization patterning techniques, or the like. In some embodiments, frontside metallization layers 1201 are fabricated over frontside contacts 911, 912, 913, 914 as discussed with respect to FIGS. 9A and 9B. In some embodiments, backside metallization layers 1202 may be fabricated over backside contact 1103.

For example, interconnectivity, signal routing, power-delivery, and the like may be provided by frontside metallization layers 1201. Adjacent metallization layers, such as metallization interconnects 1210, are interconnected by vias, such as vias 1203, that may be characterized as part of the metallization layers or between the metallization layers. As shown, in some embodiments, frontside metallization layers 1201 are formed over and immediately adjacent transistor structure 210 and diode structure 220. In the illustrated example, frontside metallization layers 1201 include M0, V0, M1, M2/V1, M3/V2, and M4/V3. However, frontside metallization layers 1201 may include any number of metallization layers such as six, eight, or more metallization layers.

Similarly, backside metallization layers 1202, may be used for interconnectivity, signal routing, power-delivery, and any other suitable electrical connectivity. In some embodiments, frontside metallization layers 1201 are used exclusively for signal routing and backside metallization layers 1202 are used exclusively for power delivery. However, any interconnection architecture may be used. In the illustrated example, package level interconnects 1211 are provided on or over a device backside as bumps over a passivation layer 1205. However, package level interconnects 1211 may be provided using any suitable interconnect structures such as bond pads, solder bumps, etc. As shown, in some embodiments, backside metallization layers 1202 are formed over and immediately adjacent transistor structure 1200 such that a device layer 1204 including transistor structure 210 and diode structure 220 is between frontside metallization layers 1201 and backside metallization layers 1202. In the illustrated example, backside metallization layers 1202 include BM0, BM1, and BM2 with intervening via layers. However, backside metallization layers 1202 may include any number of metallization layers such as three, four, or more metallization layers.

In some embodiments, transistor structure 210 and diode structure 220 are deployed in a monolithic integrated circuit (IC) die 1207 including a gate-all-around field effect transistor structure (e.g., a GAA-FET) and a diode structure, the GAA-FET transistor structure and diode structure including any of the discussed components and characteristics. As shown, a power supply 1206 may be coupled to IC die 1207, such that power supply 1206 may include a battery, voltage converter, power supply circuitry, or the like.

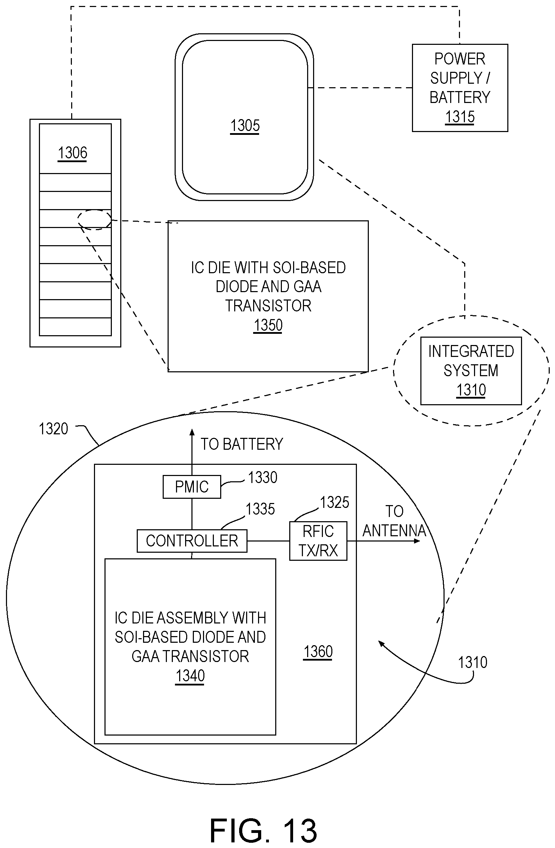

FIG. 13 illustrates exemplary systems employing an integrated circuit assembly including an integrated circuit die having a GAA-FET with semiconductor structures within a thickness of a semiconductor layer of a diode semiconductor, in accordance with some embodiments of the present disclosure. The system may be a mobile computing platform 1305 and/or a data server machine 1306, for example. Either may employ a component assembly including an IC die having a GAA-FET with semiconductor structures within a thickness of a semiconductor layer of a diode semiconductor and any other features described elsewhere herein. Server machine 1306 may be any commercial server, for example including any number of high-performance computing platforms disposed within a rack and networked together for electronic data processing, which in the exemplary embodiment includes an IC die assembly 1350 with an IC die having a GAA-FET with semiconductor structures within a thickness of a semiconductor layer of a diode semiconductor and any other features described elsewhere herein. Mobile computing platform 1305 may be any portable device configured for each of electronic data display, electronic data processing, wireless electronic data transmission, or the like. For example, mobile computing platform 1305 may be any of a tablet, a smart phone, a laptop computer, etc., and may include a display screen (e.g., a capacitive, inductive, resistive, or optical touchscreen), a chip-level or package-level integrated system 1310, and a battery 1315. Although illustrated with respect to mobile computing platform 1305, in other examples, chip-level or package-level integrated system 1310 and a battery 1315 may be implemented in a desktop computing platform, an automotive computing platform, an internet of things platform, or the like. As discussed below, in some examples, the disclosed systems may include a sub-system 1360 such as a system on a chip (SOC) or an integrated system of multiple ICs, which is illustrated with respect to mobile computing platform 1305.

Whether disposed within integrated system 1310 illustrated in expanded view 1320 or as a stand-alone packaged device within data server machine 1306, sub-system 1360 may include memory circuitry and/or processor circuitry 1340 (e.g., RAM, a microprocessor, a multi-core microprocessor, graphics processor, etc.), a power management integrated circuit (PMIC) 1330, a controller 1335, and a radio frequency integrated circuit (RFIC) 1325 (e.g., including a wideband RF transmitter and/or receiver (TX/RX)). As shown, one or more IC dies, such as memory circuitry and/or processor circuitry 1340 may be assembled and implemented such that one or more have a GAA-FET with semiconductor structures within a thickness of a semiconductor layer of a diode semiconductor and any other features described elsewhere herein. In some embodiments, RFIC 1325 includes a digital baseband and an analog front-end module further comprising a power amplifier on a transmit path and a low noise amplifier on a receive path). Functionally, PMIC 1330 may perform battery power regulation, DC-to-DC conversion, etc., and so has an input coupled to battery 1315, and an output providing a current supply to other functional modules. As further illustrated in FIG. 13, in the exemplary embodiment, RFIC 1325 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. Memory circuitry and/or processor circuitry 1340 may provide memory functionality for sub-system 1360, high level control, data processing and the like for sub-system 1360. In alternative implementations, each of the SOC modules may be integrated onto separate ICs coupled to a package substrate, interposer, or board.

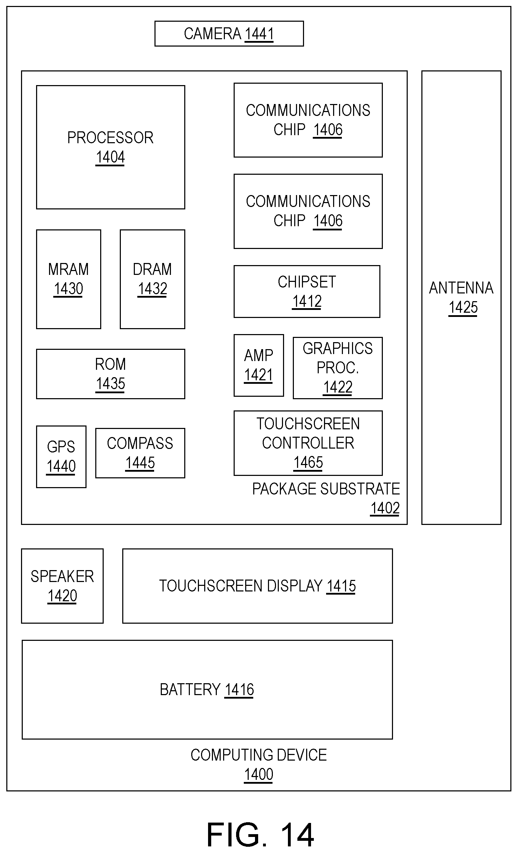

FIG. 14 is a functional block diagram of an electronic computing device 1400, in accordance with some embodiments. For example, device 1400 may, via any suitable component therein, have a GAA-FET with semiconductor structures within a thickness of a semiconductor layer of a diode semiconductor and any other features described elsewhere herein. Device 1400 further includes a motherboard or package substrate 1402 hosting a number of components, such as, but not limited to, a processor 1404 (e.g., an applications processor). Processor 1404 may be physically and/or electrically coupled to package substrate 1402. In some examples, processor 1404 is within an IC assembly that includes an IC die having a GAA-FET with semiconductor structures within a thickness of a semiconductor layer of a diode semiconductor and any other features described elsewhere herein. In general, the term "processor" or "microprocessor" may refer to any device or portion of a device that processes electronic data from registers and/or memory to transform that electronic data into other electronic data that may be further stored in registers and/or memory.

In various examples, one or more communication chips 1406 may also be physically and/or electrically coupled to the package substrate 1402. In further implementations, communication chips 1406 may be part of processor 1404. Depending on its applications, computing device 1400 may include other components that may or may not be physically and electrically coupled to package substrate 1402. These other components include, but are not limited to, volatile memory (e.g., DRAM 1432), non-volatile memory (e.g., ROM 1435), flash memory (e.g., NAND or NOR), magnetic memory (MRAM 1430), a graphics processor 1422, a digital signal processor, a crypto processor, a chipset 1412, an antenna 1425, touchscreen display 1415, touchscreen controller 1465, battery 1416, audio codec, video codec, power amplifier 1421, global positioning system (GPS) device 1440, compass 1445, accelerometer, gyroscope, speaker 1420, camera 1441, and mass storage device (such as hard disk drive, solid-state drive (SSD), compact disk (CD), digital versatile disk (DVD), and so forth, or the like.

Communication chips 1406 may enable wireless communications for the transfer of data to and from the computing device 1400. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chips 1406 may implement any of a number of wireless standards or protocols, including, but not limited to, those described elsewhere herein. As discussed, computing device 1400 may include a plurality of communication chips 1406. For example, a first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, Ev-DO, and others.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the invention is not limited to the embodiments so described, but can be practiced with modification and alteration without departing from the scope of the appended claims. For example the above embodiments may include specific combinations of features as further provided below.

The following pertains to exemplary embodiments.

In one or more first embodiments, an apparatus comprises a diode structure within an integrated circuit (IC) die, the diode structure comprising one or more contacts coupled to a top surface of a semiconductor layer comprising a diode junction, such that the semiconductor layer has a thickness extending orthogonally from the top surface to a bottom surface of the semiconductor layer, and such that the bottom surface is on an insulator layer, and a transistor structure within the IC die, the transistor structure comprising a stack of semiconductor structures extending between a source and a drain, and a gate structure coupled to each of the semiconductor structures, such that each of the semiconductor structures is laterally within the thickness of the semiconductor layer and over the insulator layer.

In one or more second embodiments, further to the first embodiments, the bottom surface of the semiconductor layer of the diode structure defines a first plane not less than 6 nm and not more than 12 nm below a second plane defined by a bottom surface of a lower-most one of the semiconductor structures.

In one or more third embodiments, further to the first or second embodiments, the gate structure comprises a gate dielectric on each of the semiconductor structures and a gate metal on the gate dielectric, and a portion of the gate metal extends from a first portion of the gate dielectric on a bottom surface of a lower-most one of the semiconductor structures to a second portion of the gate dielectric on the insulator layer.

In one or more fourth embodiments, further to the first through third embodiments, the portion of the gate metal is a first portion of the gate metal having a first surface adjacent the insulator layer, and a second portion of the gate metal laterally adjacent to the first portion of the gate metal has a second surface adjacent the insulator layer that is offset toward the insulator layer by not less than 2 nm relative to the first surface.

In one or more fifth embodiments, further to the first through fourth embodiments, the apparatus further comprises a backside contact embedded in the insulator layer and coupled to the source of the transistor structure.

In one or more sixth embodiments, further to the first through fifth embodiments, the top surface of the semiconductor layer defines a third plane not less than 6 nm and not more than 12 nm above a fourth plane defined by a top surface of an upper-most one of the semiconductor structures.

In one or more seventh embodiments, further to the first through sixth embodiments, the diode structure comprises a diode or a bipolar junction transistor.

In one or more eighth embodiments, further to the first through seventh embodiments, the semiconductor layer and the stack of semiconductor structures each comprises monocrystalline silicon.

In one or more ninth embodiments, further to the first through eighth embodiments, the apparatus further comprises a power supply coupled to the IC die.

In one or more tenth embodiments, an apparatus comprises a diode structure within an integrated circuit (IC) die, the diode structure comprising one or more contacts coupled to a top surface of a semiconductor layer comprising a diode junction, such that the semiconductor layer has a bottom surface opposite the top surface and a thickness extending therebetween, and such that the bottom surface is on an insulator layer, and a transistor structure within the IC die, the transistor structure comprising a stack of semiconductor structures extending parallel to the top surface of the semiconductor layer from a source to a drain and over the insulator layer, and a gate structure comprising a gate dielectric on each of the semiconductor structures and a gate metal on the gate dielectric, such that each of the semiconductor structures is laterally within the thickness of the semiconductor layer with a bottom surface of a lower-most one of the semiconductor structures offset by the bottom surface of the semiconductor layer by not less than 4 nm.

In one or more eleventh embodiments, further to the tenth embodiments, the bottom surface of the lower-most one of the semiconductor structures is offset by the bottom surface of the semiconductor layer by not less than 6 nm and not more than 12 nm.

In one or more twelfth embodiments, further to the tenth or eleventh embodiments, the top surface of the semiconductor layer defines a third plane not less than 6 nm and not more than 12 nm above a fourth plane defined by a top surface of an upper-most one of the semiconductor structures.

In one or more thirteenth embodiments, further to the tenth through twelfth embodiments, the diode structure comprises a diode or a bipolar junction transistor.

In one or more fourteenth embodiments, further to the tenth through thirteenth embodiments, the apparatus further comprises a power supply coupled to the IC die.

In one or more fifteenth embodiments, a method comprises receiving a substrate comprising a semiconductor material on an insulator layer, forming a well comprising a sidewall and a bottom surface within the semiconductor material, such that forming the well forms a thinned portion of the semiconductor material, the thinned portion having a thickness between the bottom surface of the well and the insulator layer of not more than 5 nm, forming a multilayer stack of interleaved semiconductor layers and sacrificial layers within the well, forming a transistor structure within the well, the transistor structure comprising nanowires formed from the semiconductor layers, and forming a diode structure comprising the semiconductor material.

In one or more sixteenth embodiments, further to the fifteenth embodiments, forming the transistor structure comprises patterning the multilayer stack and the thinned portion of the semiconductor material to define a fin structure, and removing the sacrificial layers, portions of the semiconductor layers, and the thinned portion of the semiconductor material from the fin structure to release the nanowires.

In one or more seventeenth embodiments, further to the fifteenth or sixteenth embodiments, forming the transistor structure comprises diffusing atoms of the sacrificial layers into the portions of the semiconductor layers and the thinned portion of the semiconductor material prior to removing the sacrificial layers, the portions of the semiconductor layers, and the thinned portion of the semiconductor material.

In one or more eighteenth embodiments, further to the fifteenth through seventeenth embodiments, forming the diode structure comprises contacting a top surface of the semiconductor material with one or more first contacts, and such that forming the transistor structure comprises simultaneously contacting a source, drain, or gate with a second contact.

In one or more nineteenth embodiments, further to the fifteenth through eighteenth embodiments, the method further comprises removing a bulk layer of the substrate using the insulator layer as a selective stop layer.

In one or more twentieth embodiments, further to the fifteenth through nineteenth embodiments, the method further comprises contacting the transistor structure with a third contact embedded in insulator layer.

It will be recognized that the invention is not limited to the embodiments so described, but can be practiced with modification and alteration without departing from the scope of the appended claims. For example, the above embodiments may include specific combination of features. However, the above embodiments are not limited in this regard and, in various implementations, the above embodiments may include the undertaking only a subset of such features, undertaking a different order of such features, undertaking a different combination of such features, and/or undertaking additional features than those features explicitly listed. The scope of the invention should, therefore, be determined with reference to the appended claims, along with the full scope of equivalents to which such claims are entitled.

## Claims

1. An apparatus, comprising:
a diode structure within an integrated circuit (IC) die, the diode structure comprising one or more contacts coupled to a top surface of a semiconductor layer comprising a diode junction, wherein the semiconductor layer has a thickness extending orthogonally from the top surface to a bottom surface of the semiconductor layer, and wherein the bottom surface is on an insulator layer; and
a transistor structure within the IC die, the transistor structure comprising a stack of semiconductor structures extending between a source and a drain, and a gate structure coupled to each of the semiconductor structures,
wherein each of the semiconductor structures is laterally within the thickness of the semiconductor layer and over the insulator layer.

2. The apparatus of claim 1, wherein the bottom surface of the semiconductor layer of the diode structure defines a first plane not less than 6 nm below a second plane defined by a bottom surface of a lower-most one of the semiconductor structures.

3. The apparatus of claim 2, wherein the first plane is not more than 12 nm below the second plane.

4. The apparatus of any of claims 1 to 3, wherein the gate structure comprises a gate dielectric on each of the semiconductor structures and a gate metal on the gate dielectric, and wherein a portion of the gate metal extends from a first portion of the gate dielectric on a bottom surface of a lower-most one of the semiconductor structures to a second portion of the gate dielectric on the insulator layer.

5. The apparatus of claim 4, wherein the portion of the gate metal is a first portion of the gate metal having a first surface adjacent the insulator layer, and wherein a second portion of the gate metal laterally adjacent to the first portion of the gate metal has a second surface adjacent the insulator layer that is offset toward the insulator layer by not less than 2 nm relative to the first surface.

6. The apparatus of any of claims 1 to 5, further comprising a backside contact embedded in the insulator layer and coupled to the source of the transistor structure.

7. The apparatus of any of claims 1 to 6, wherein the top surface of the semiconductor layer defines a third plane not less than 6 nm and not more than 12 nm above a fourth plane defined by a top surface of an upper-most one of the semiconductor structures.

8. The apparatus of any of claims 1 to 7, wherein the diode structure comprises a diode or a bipolar junction transistor.

9. The apparatus of any of claims 1 to 8, wherein the semiconductor layer and the stack of semiconductor structures each comprises monocrystalline silicon.

10. The apparatus of any of claims 1 to 9, further comprising:
a power supply coupled to the IC die.

11. A method, comprising:
receiving a substrate comprising a semiconductor material on an insulator layer;
forming a well comprising a sidewall and a bottom surface within the semiconductor material, wherein forming the well forms a thinned portion of the semiconductor material, the thinned portion having a thickness between the bottom surface of the well and the insulator layer of not more than 5 nm;
forming a multilayer stack of interleaved semiconductor layers and sacrificial layers within the well;
forming a transistor structure within the well, the transistor structure comprising nanowires formed from the semiconductor layers; and
forming a diode structure comprising the semiconductor material.

12. The method of claim 11, wherein forming the transistor structure comprises:
patterning the multilayer stack and the thinned portion of the semiconductor material to define a fin structure; and
removing the sacrificial layers, portions of the semiconductor layers, and the thinned portion of the semiconductor material from the fin structure to release the nanowires.

13. The method of claim 11 or 12, wherein forming the transistor structure comprises: diffusing atoms of the sacrificial layers into the portions of the semiconductor layers and the thinned portion of the semiconductor material prior to removing the sacrificial layers, the portions of the semiconductor layers, and the thinned portion of the semiconductor material.

14. The method of any of claims 11 to 13, wherein forming the diode structure comprises contacting a top surface of the semiconductor material with one or more first contacts, and wherein forming the transistor structure comprises simultaneously contacting a source, drain, or gate with a second contact.

15. The method of claim 14, further comprising:
removing a bulk layer of the substrate using the insulator layer as a selective stop layer; and contacting the transistor structure with a third contact embedded in insulator layer.
